# EUROPÄISCHE PATENTSCHRIFT

(11) **EP 0 897 220 B1**
(45) Veröffentlichungstag und Bekanntmachung des Hinweises auf die Patenterteilung: **01.09.2004**
(21) Anmeldenummer: 98111748.4
(22) Anmeldetag: 25.06.1998
(51) Int. Cl.: H03K 23/66, H03K 23/68

(54) **Frequenzteileranordnung**
Frequency divider
Diviseur de fréquence

(30) Priorität: 12.08.1997 DE 19734930
(43) Veröffentlichungstag der Anmeldung: 17.02.1999
(73) Patentinhaber: Infineon Technologies AG, 81669 München (DE)
(72) Erfinder: Wagner, Wolfgang, 81539 München (DE)
(74) Vertreter: Jannig, Peter, Dipl.-Ing.

(56) Entgegenhaltungen:
- US-A- 4 223 268
- T. H. HILLOCK: "digital non-integer frequency divider" IBM TECHNICAL DISCLOSURE BULLETIN., Bd. 20, Nr. 12, Mai 1978 (1978-05), Seite 5214 XP002119185 IBM CORP. NEW YORK., US ISSN: 0018-8689

## Beschreibung

Die Erfindung betrifft eine Frequenzteileranordnung zur Erzeugung eines Ausgangstaktsignals mit einer einstellbaren Ausgangstaktfrequenz aus einem Eingangstaktsignal mit einer Eingangstaktfrequenz unter Verwendung von einstellbaren Teilern.

Derartige Frequenzteiler werden beispielsweise verwendet, um aus einem vorgegebenen, von einem Quarzoszillator abgeleiteten Takt eine Vielzahl von Ausgangsfrequenzen zu erzeugen. Das Ausgangssignal dient zur Synchronisation eines asynchron eingespeisten Datensignals auf die Ausgangsfrequenz. Durch Einstellung des Teilers sind ausgehend vom fest vorgegebenen Systemtakt eine Vielzahl von Ausgangsfrequenzen zur Synchronisation ableitbar.

Bei bisherigen Schaltungen wird der quarzstabile Eingangstakt einem herkömmlichen synchronen Teiler zugeführt, dessen Teilerverhältnis 1/L einstellbar ist. Die Ausgangsfrequenz dient dann zur Synchronisation des eingangsseitigen Datensignals. Als einstellbarer Teiler eignet sich ein Abwärtszähler, der abhängig vom einstellbaren Teilerverhältnis mit einem Startwert geladen wird und nach einem Impuls des Eingangssignals bis zum Zählerstand 0 herunterzählt und dann einen Ausgangsimpuls abgibt. Die Frequenz des Ausgangssignals ist vom voreinstellbaren Startwert abhängig. Für die Ausgangsfrequenz fout dieser bisherigen Schaltung in Abhängigkeit von der Eingangsfrequenz fin und dem Teilerfaktor L ergibt sich fout = fin/L. In T.H. HILLOCK, 'digital non-integer frequency divider' ; IBM TECHNICAL DISCLOSURE BULLTIN, Bd. 20, Nr 12, Mai 1978 ist ein Frequenteiler offenbart, der es erlaubt eine Frequenz nicht-ganzzahlig zu teilen, wobei das Teilerverhältnis jedoch nicht einstellbar ist.

Zur Synchronisation eines asynchron eingespeisten digitalen Datensignals auf die durch oben beschriebene Schaltung erzeugte Ausgangsfrequenz sind gewisse Genauigkeitsanforderungen für die Ausgangsfrequenz einzuhalten. Liegen die Datenbytes des zur Synchronisation anstehenden Dateneingangssignals in einem Format von 8 Bit sowie zusätzlich einem Startbit und einem Stopbit vor, darf die erzeugte Ausgangsfrequenz fout nicht mehr als 5% vom Idealwert abweichen, um das eingespeiste Datensignal noch korrekt abzutasten. Da der Teilerwert L nur ganzzahlig ist, läßt sich eine Genauigkeitsanforderung von kleiner oder gleich 5% bei einem Wert von L in der Größenordnung von 20 oder darunter nicht mehr sicher erreichen. Bei vorgegebenem Systemquarztakt ist daher eine sichere Synchronisation nur innerhalb eines eingeschränkten Frequenzbereichs des eingespeisten digitalen Datensignals möglich. Die Frequenzabweichung des erzeugten Ausgangssignals vom ideal zu fordernden Wert ist bei niedrigen Frequenzen geringer (L ist groß) als bei hohen Frequenzen (L ist klein). Hohe Frequenzen werden daher durch die beschriebene Schaltung mit geringerer Genauigkeit erzeugt als niedrige Frequenzen. Dem heutigen Trend zu immer höheren Taktraten für Datensignale, die zu synchronisieren sind, kann das beschriebene Konzept nicht mehr folgen.

Die Aufgabe der Erfindung besteht deshalb darin, eine Frequenzteileranordnung der eingangs beschriebenen Art anzugeben, durch die Ausgangstaktfrequenzen in einem breiten Wertebereich, insbesondere auch für höhere Ausgangsfrequenzen, genauer einstellbar sind.

Efindungsgemäß wird diese Aufgabe durch eine Frequenzteileranordnung nach den Merkmalen des Patentanspruchs 1 gelöst.

Weiterbildungen der Erfindung sind in den Unteransprüchen angegeben. Nachfolgend wird die Erfindung anhand des in der Zeichnung dargestellten Ausführungsbeispiels näher erläutert.

Es zeigen:
- Figur 1: ein Schaltbild der erfindungsgemäßen Frequenzteileranordnung,
- Figur 2: ein Signaldiagramm von in der Figur 1 vorkommenden Signalen und
- Figur 3: eine Realisierung für den in Figur 1 gezeigten einstellbaren synchronen Teiler.

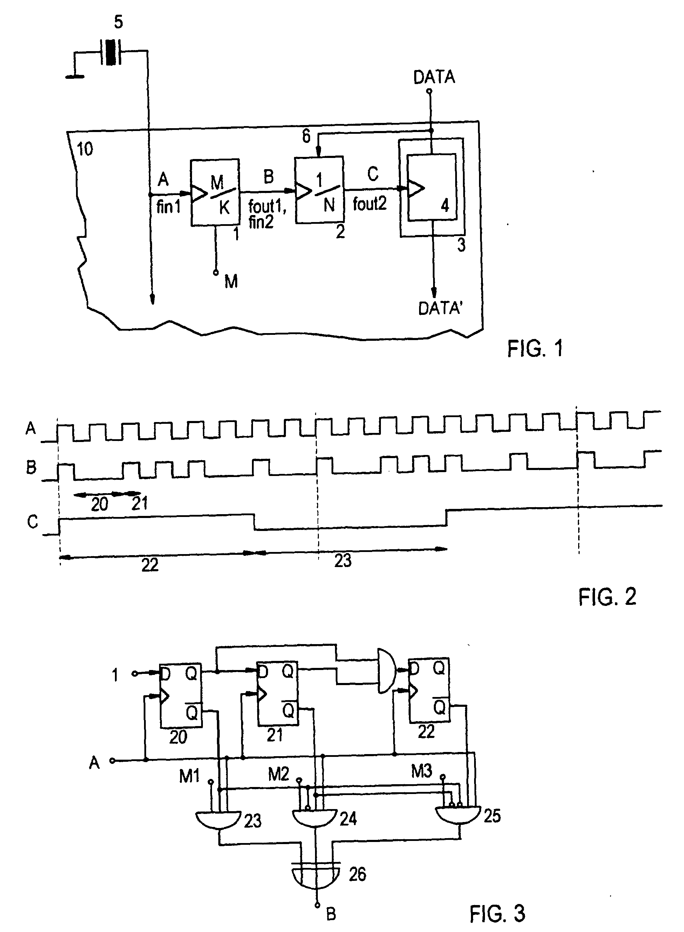

Figur 1 zeigt einen relevanten Ausschnitt aus einem Microcontroller 10. In den Microcontroller 10 wird ein von einem Quarzoszillator 5 abgeleiteter quarzstabiler Takt A mit einer Frequenz fin1 eingespeist. Durch das Taktsignal A werden sowohl die erfindungsgemäße Frequenzteileranordnung als auch die übrigen Funktionseinheiten des Microcontrollers 10 angesteuert, wie beispielsweise die CPU des Microcontrollers. Der Quarzoszillator 5 bildet daher die Basis des Systemtaktes, indem nahezu alle im Microcontroller 10 erforderlichen Taktsignale vom quarzstabilen Taktsignal A abgeleitet werden. Der Microcontroller 10 weist eine Einrichtung 3 auf, in die ein digitales Datensignal DATA eingespeist wird, das auf eine Taktsignal synchronisiert wird. Das durch die Einrichtung 3 erzeugte Ausgangsdatensignal DATA' ist somit auf den Systemtakt A zur weiteren Verarbeitung im Microcontroller 10 synchronisiert. Hierzu weist die Einrichtung 3 wie herkömmlich im wesentlichen ein Speicherelement 4 auf, in das die Eingangsdaten DATA mit dem Taktsignal C eingeschrieben werden, d.h. das Eingangdatensignal DATA wird mit dem Taktsignal C abgetastet.

Das Taktsignal C wird aus dem Eingangstakt A durch einen synchronen einstellbaren ersten Teiler 1 und einen diesem nachgeschaltetem weiteren Teiler 2 erzeugt. Das vom Teiler 1 erzeugte Ausgangssignal B weist die Frequenz fout1 auf. Die Ausgangsfrequenz fout1 ist durch einen in den Teiler 1 einspeisbaren ganzzahligen Wert M einstellbar. Die Ausgangsfrequenz fout1 ergibt sich in Abhängigkeit von der Eingangsfrequenz fin1 und dem Wert M gemäß dem Zusammenhang fout1 = M/K · fin1. Der Wert K ist ganzzahlig und durch die Struktur des Teilers 1 hardwaremäßig festgelegt. Außerdem gilt M < K.

In Figur 2 ist das Eingangstaktsignal A dargestellt, sowie das durch den Teiler 1 erzeugte Taktsignal B, wobei K = 8 und M = 5 gilt. Das Signal B weist während eines Zeitabschnitts nur einen Anteil von 5/8 von Impulsen verglichen mit dem Eingangstaktsignal A auf. Der Teiler 1 arbeitet synchron zum Eingangstakt A, so daß die Ausgangstaktimpulse ebenfalls synchron zu den Impulsen des Taktsignals A vorliegen. Benachbarte Impulse des Taktsignals B können daher unterschiedlichen Abstand voneinander haben. Während im Taktsignal A das Verhältnis von Low- zu High-Phasen ausgeglichen ist, kann im Signal B das Verhältnis von Low zu High schwanken und wie mit den Bezugszeichen 20 und 21 bezeichnet, relativ unsymmetrisch sein.

Durch den Teiler 2 wird das Taktsignal B um ein konstantes Teilerverhältnis 1/N geteilt. Im Ausführungsbeispiel gilt N = 4. Das vom Teiler 2 erzeugte Ausgangssignal C ist in Figur 2 dargestellt. Das Verhältnis von Low- zu High-Zeitabschnitten im Taktsignal C ist wiederum weitgehend ausgeglichen, wie anhand der Signalabschnitte 22 und 23 dargestellt ist. Zwar wird das Verhältnis von Low- zu High-Signalabschnitten im Taktsignal C nicht ideal ausgeglichen (d.h. 1:1) sein, wie im Fall des Eingangstaktsignals A. Die Abweichung davon hält sich jedoch im Rahmen der erforderlichen Genauigkeit, so daß die Impulse des Datensignals DATA zeitrichtig abgetastet werden.

Obwohl zuerst durch den einstellbaren Teiler 1 Impulse mit unterschiedlichem Abstand zueinander erzeugt werden, von denen angenommen werden müßte, daß sie an sich wegen dieser Eigenschaft nicht zur Synchronisation des Eingangsdatensignals DATA geeignet wären, wird durch die Nachschaltung des Teilers 2 der überraschende Effekt erzielt, daß sich ein Ausgangstaktsignal C ergibt, welches ein im Rahmen der Genauigkeitsanforderungen ausgeglichenes und somit zur Synchronisation geeignetes Taktsignal ist.

Der Teiler 2 ist ein herkömmlicher Teiler 1/N, bei dem sich die Ausgangsfrequenz fout2 in Abhängigkeit von seiner Eingangsfrequenz fin2 ergibt aus der Beziehung fout2 = 1/N · fin2. Hierzu wird wie eingangs beschrieben ein Abwärtszähler verwendet. Der Teiler 2 arbeitet synchron zu seinem Eingangstaktsignal B. Darüber hinaus wird der Teiler 2 über eine Verbindung 6 auf eine ansteigende Flanke des Datensignals DATA getriggert, so daß durch das Taktsignal C ein Abtasten der Bits des Datensignals DATA in vorgegebenem Abstand von der ansteigenden Flanke, vorzugsweise in der zu erwartenden Mitte des Datenbitimpulses, möglich ist.

In der erfindungsgemäßen Frequenzteileranordnung ist die Schrittweite der Frequenz fout1 des Signals B unabhängig von der zu erzeugenden Ausgangsfrequenz konstant, nämlich fin1/K. Im Gegensatz zum Stand der Technik sind somit auch hohe Frequenzen mit ausreichend guter Genauigkeit realisierbar. Entsprechendes gilt für die Ausgangsfrequenz fout2 des Ausgangstaktsignals C. Die nachfolgende Tabelle zeigt diesen Effekt im Vergleich zu einem einleitend beschriebenen einstellbaren Teiler mit Teilerfaktor 1/L nach dem Stand der Technik. Die Systemfrequenz beträgt 12,5 MHz. Der Teiler 2 bzw. ein dem Teiler 1/L gemäß dem Stand der Technik nachgeschalteter entsprechender Teiler weist ein Teilerverhältnis 1/N = 1/16 auf.

**Tabelle**

| System-frequenz in MHz | Daten-raten in Bit/s | Stand der Technik | | | Erfindung, K = 2048 | | |
|---|---|---|---|---|---|---|---|
| | | L | Ausgangsfrequenz in Bit/s | Fehler in % | M | Ausgangsfrequenz in Bit/s | Fehler in % |
| 12,5 | 9.600 | 81 | 9.645,06 | 0,47 | 25 | 9.536,74 | -0,66 |
| 12,5 | 19.200 | 40 | 19.531,25 | 1,73 | 50 | 19.073,49 | -0,66 |
| 12,5 | 38.400 | 20 | 39.062,50 | 1,73 | 100 | 38.146,97 | -0,66 |
| 12,5 | 56.000 | 13 | 60.096,15 | 7,31 | 146 | 55.694,58 | -0,55 |
| 12,5 | 64.000 | 12 | 65.104,17 | 1,73 | 167 | 63,705,44 | -0,46 |
| 12,5 | 115.200 | 6 | 130.208,35 | 13,03 | 301 | 114.822,39 | -0,33 |

Es ist zu erkennen, daß bei einem Teiler 1/L nach dem Stand der Technik mit höheren Datenraten, d.h. kleinerem L, der Fehler zunimmt. Bei der Erfindung hingegen nimmt der Fehler mit zunehmenden Datenraten ab und bleibt stets unterhalb der zu fordernden Genauigkeit von 5% für das oben beschriebene Beispiel.

Zur Realisierung des in der erfindungsgemäßen Schaltung zu verwendenden Teilers 1 wird auf die Veröffentlichungen "Das TTL-Kochbuch", 1972, Seiten 154 bis 157 sowie auf Datenbuch TEXAS Instruments, Februar 1971, Seiten 9-35 und 9-40, Circuit Types SN7497, SN74167 verwiesen.

Dementsprechend ist die Realisierung des Teilers 1 im beschriebenen Ausführungsbeispiel der Figuren 1 und 2 in Figur 3 dargestellt. Der Teiler weist einen vom Eingangstakt A synchron angesteuerten Dualzähler umfassend die Flip-Flops 20, 21, 22 auf. Ausgangsseitig an jedem Flip-Flop ist ein UND-Gatter 23, 24 bzw. 25 angeordnet, dem das Eingangstaktsignal A, der jeweils negierte Ausgang des zugeordneten Flip-Flops und die positiven Ausgangssignale der jeweils niederwertigeren Flip-Flops zugeführt werden. Außerdem wird den UND-Gattern 23, 24, 25 je ein Bit des einstellbaren Werts M, nämlich M1, M2 bzw. M3, zugeführt. Die Konstante K ist durch die Struktur des Teilers 1 fest vorgegeben. Im dargestellten Fall sind drei Flip-Flops 20, 21, 22 vorgesehen, so daß K = 8 mit M < K gilt.

## Patentansprüche

1. Frequenzteileranordnung zur Erzeugung eines Ausgangstaktsignals (C) mit einer einstellbaren Ausgangstaktfrequenz aus einem Eingangstaktsignal (A) mit einer Eingangstaktfrequenz, umfassend einen einstellbaren synchronen ersten Teiler (1), dem das Eingangstaktsignal (A) zuführbar ist und dessen Ausgangstaktfrequenz fout1 sich in Abhängigkeit von seiner Eingangstaktfrequenz fin1 gemäß der Beziehung fout1 = M/K * fin1 verhält, wobei K ganzzahlig konstant vorgegeben ist und M ganzzahlig durch ein Eingangssteuersignal einstellbar ist, und einen dem ersten Teiler (1) nachgeschalteten zweiten Teiler (2), an dem ausgangsseitig das Ausgangstaktsignal (C) abgreifbar ist und dessen Ausgangstaktfrequenz fout2 sich in Abhängigkeit von seiner Eingangstaktfrequenz fin2 gemäß der Beziehung fout2 = 1/N * fin2 verhält.

2. Frequenzteiler nach Anspruch 1,
**gekennzeichnet durch**
ein Speicherelement (4), das **durch** das Ausgangstaktsignal (C) taktsteuerbar ist, zur Synchronisation eines asynchronen Eingangsdatensignals (DATA) auf die Ausgangstaktfrequenz.

3. Frequenzteiler nach Anspruch 2,
**gekennzeichnet durch**
Anordnung in einem Mikrocontroller (10), bei dem die Eingangstaktfrequenz des Eingangstaktsignals (A) an ein Taktnormal (5) gekoppelt ist, von dem außerdem die Taktsteuerung weiterer Funktioneinheiten des Mikrocontrollers (10) abgeleitet ist.

4. Frequenzteiler nach Anspruch 3,
**dadurch gekennzeichnet, daß**
das Taktnormal durch einen Quarzoszillator (5) bereitgestellt wird.

## Claims

1. Frequency divider arrangement for generating an output clock signal (C) having an adjustable output clock frequency from an input clock signal (A) having an input clock frequency, comprising an adjustable, synchronous first divider (1), to which the input clock signal (A) can be fed and whose output clock frequency fout1 is a function of its input clock frequency fin1 in accordance with the relationship fout1 = M/K * fin1, where K is a constant predetermined integer and M is an integer which can be adjusted by an input control signal, and a second divider (2), which is connected downstream of the first divider (1) and at whose output the output clock signal (C) can be picked off and whose output clock frequency fout2 is a function of its input clock frequency fin2 in accordance with the relationship fout2 = 1/N * fin2.

2. Frequency divider according to Claim 1,
**characterized by** a storage element (4), which can be clocked by the output clock signal (C), for synchronizing an asynchronous input data signal (DATA) with the output clock frequency.

3. Frequency divider according to Claim 2,
**characterized by** arrangement in a microcontroller (10), in which the input clock frequency of the input clock signal (A) is coupled to a clock signal standard (5), from which the clock signal control of further functional units of the microcontroller (10) is additionally derived.

4. Frequency divider according to Claim 3,
**characterized in that** the clock signal standard is provided by a crystal oscillator (5).

## Revendications

1. Agencement diviseur de fréquence pour la génération d'un signal de cadence de sortie (C) avec une fréquence de cadence de sortie réglable à partir d'un signal de cadence d'entrée (A) avec une fréquence de cadence d'entrée comprenant un premier diviseur (1) synchrone réglable, auquel le signal de cadence d'entrée (A) peut être amené et dont la fréquence de cadence de sortie fout1 se comporte en fonction de sa fréquence de cadence d'entrée fin1 selon la relation fout1 = M/K * fin1, K étant prédéfinie constante et entière et M étant un nombre entier et réglable par un signal de commande d'entrée, et un second diviseur (2) placé en aval du premier diviseur (1), sur lequel le signal de cadence de sortie (C) peut être prélevé côté sortie et dont la fréquence de cadence de sortie fout2 se comporte en fonction de sa fréquence de cadence d'entrée fin2 selon la relation fout2 = 1/N * fin2.

2. Diviseur de fréquence selon la revendication 1,
**caractérisé par** un élément de mémoire (4), qui peut être contrôlé au niveau de la cadence par le signal de cadence de sortie (C), pour la synchronisation d'un signal de données d'entrée (DATA) asynchrone par rapport à la fréquence de cadence de sortie.

3. Diviseur de fréquence selon la revendication 2,
**caractérisé par** un agencement dans un microcontrôleur (10), avec lequel la fréquence de cadence d'entrée du signal de cadence d'entrée (A) est couplée à une valeur normale de cadence (5), de laquelle est déduite également la commande de cadence d'autres unités fonctionnelles du microcontrôleur (10) .

4. Diviseur de fréquence selon la revendication 3,
**caractérisé en ce que** la valeur normale de cadence est mise à disposition par un oscillateur à quartz (5).
